# EUROPEAN PATENT APPLICATION

(11) **EP 4 687 171 A1**
(43) Date of publication of application: **04.02.2026**
(21) Application number: 24192058.6
(22) Date of filing: 31.07.2024
(51) Int. Cl.: H01L 21/67, H01L 21/687

(54) **METHOD AND APPARATUS FOR BONDING SUBSTRATES**

(71) Applicant: ASML Netherlands B.V., 5500 AH Veldhoven (NL)
(72) Inventor: HSU, Chia-Hao, 5500 AH Veldhoven (NL); NIKIPELOV, Andrey, 5500 AH Veldhoven (NL)
(74) Representative: ASML Netherlands B.V.

(57) **Abstract**

Disclosed is a method of bonding a first substrate to a second substrate, the first substrate comprising a first bonding surface and a plurality of first electrically conductive pads protruding from, or levelled with, or recessed from the first bonding surface and the second substrate comprising a second bonding surface and a plurality of second electrically conductive pads protruding from, or levelled with, or recessed from the second bonding surface, the method comprising: reducing a distance between the first bonding surface and the second bonding surface; selectively depositing a dielectric layer onto the first bonding surface and/or the second bonding surface to fill a gap therebetween; and bringing each of the first electrically conductive pads into electrical contact with a respective one of the second electrically conductive pads so as to obtain a bonded substrate.

## Description

### BACKGROUND

### Field of the Invention

The present invention relates to a method and apparatus for bonding two or more substrates together, in particular how to improve the performance of bonding processes.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In order to monitor the lithographic process, parameters of the patterned substrate are measured. Parameters may include, for example, the overlay error between successive layers formed in or on the patterned substrate and critical linewidth (CD) of developed photosensitive resist. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured. Two main types of scatterometer are known. Spectroscopic scatterometers direct a broadband radiation beam onto the substrate and measure the spectrum (intensity as a function of wavelength) of the radiation scattered into a particular narrow angular range. Angularly resolved scatterometers use a monochromatic radiation beam and measure the intensity of the scattered radiation as a function of angle.

Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

Process control methods are used in the manufacture of integrated devices to monitor and control the processes of application of a pattern on a substrate or measurement of such a pattern. Such process control techniques are typically performed to obtain corrections for control of the process. Subsequently, it is sometimes required (for certain devices) to bond substrates together. Bonding processes include die-to-die, die-to-wafer and wafer-to-wafer. Wafer-to-wafer bonding, where whole wafers are permanently bonded together prior to dicing, has the potential of providing a high accuracy and high throughput bonding solution.

It would be desirable to improve process control methods in the manufacture of integrated devices.

### SUMMARY OF THE INVENTION

In a first aspect of the invention, there is provided a method of bonding a first substrate to a second substrate, the first substrate comprising a first bonding surface and a plurality of first electrically conductive pads protruding from, or levelled with, or recessed from the first bonding surface and the second substrate comprising a second bonding surface and a plurality of second electrically conductive pads protruding from, or levelled with, or recessed from the second bonding surface; the method comprising: reducing a distance between the first bonding surface and the second bonding surface; selectively depositing a dielectric layer onto the first bonding surface and/or the second bonding surface to fill a gap therebetween; and bringing each of the first electrically conductive pads into electrical contact with a respective one of the second electrically conductive pads.

In a second aspect of the invention, there is provided a method of bonding a first substrate to a second substrate, the first substrate comprising a first bonding surface and a plurality of first electrically conductive pads levelled with or recessed from the first bonding surface and the second substrate comprising a second bonding surface and a plurality of second electrically conductive pads levelled with or recessed from the second bonding surface, the method comprising: selectively depositing a dielectric layer onto the first bonding surface and/or the second bonding surface to adjust a first recess of the plurality of first electrically conductive pads with respect to the first bonding surface and/or a second recess of the plurality of second electrically conductive pads with respect to the second bonding surface, wherein an external surface of the dielectric layer deposited onto the first substrate is configured to provide the first bonding surface and an external surface of the dielectric layer deposited onto the second substrate is configured to provide the second bonding surface; reducing a distance between the first bonding surface and the second bonding surface; bringing at least a portion of first bonding surface into contact with a corresponding portion of the second bonding surface; and bringing each of the first electrically conductive pads into electrical contact with a respective one of the second electrically conductive pads so as to obtain a bonded substrate.

In a third aspect of the invention, there is provided a substrate bonding apparatus for bonding a first substrate to a second substrate, comprising: a first substrate clamp for securely holding a first substrate comprising a first bonding surface and a plurality of first electrically conductive pads protruding from, or levelled with, or recessed from the first bonding surface; a second substrate clamp for securely holding a second substrate comprising a second bonding surface and a plurality of second electrically conductive pads protruding from, or levelled with, or recessed from the second bonding surface; and an atomic layer deposition reactor configured to selectively deposit a dielectric layer onto the first bonding surface and the second bonding surface to fill a gap therebetween or to selectively deposit a dielectric layer onto the first bonding surface and/or the second bonding surface to adjust a first recess of the plurality of first electrically conductive pads with respect to the first bonding surface and/or a second recess of the plurality of second electrically conductive pads with respect to the second bonding surface; and a heating apparatus configured to heat up a bonded substrate so as to increase or establish electrical contact between the plurality of first electrically conductive pads and the plurality of second electrically conductive pads through heat-induced expansion and diffusion.

In a fourth aspect of the invention, there is provided a bonded substrate obtained by performing the method of the first aspect or the second aspect.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example, with reference to the accompanying drawings in which:
- Figure 1 depicts a lithographic apparatus together with other apparatuses forming a production facility for semiconductor devices;
- Figure 2 comprises a schematic diagram of a scatterometer for use in measuring targets according to embodiments of the invention;
- Figure 3 is a schematic overview of control mechanisms in a lithographic process utilizing a scanner stability module.
- Figure 4 is a flow diagram describing an existing method of manufacturing integrated devices which utilizes wafer-to-wafer bonding;
- Figure 5 is a flow diagram describing existing methods for manufacturing integrated devices which utilize wafer-to-wafer bonding;
- Figure 6 illustrates a flow for a further example implementation for determining a post-bonding lithography correction;
- Figure 7 shows a flowchart of the proposed method of bonding a first substrate to a second substrate in accordance with an embodiment;
- Figure 8 schematically depicts an example substrate bonding apparatus for implementing the proposed bonding method (e.g., the method shown in Figure 7) and a side cross-sectional view of a first (top) substrate clamp and a side cross-sectional view of a second (bottom) substrate clamp of the substrate bonding apparatus;
- Figure 9 schematically depicts an example implementation of method step 740 of the proposed method shown in Figure 7;
- Figure 10 schematically depicts an example implementation of method step 750 of the proposed method shown in Figure 7;
- Figure 11 schematically depicts an example implementation of method step 760 of the proposed method shown in Figure 7;
- Figure 12 schematically depicts an example implementation of method step 770 of the proposed method shown in Figure 7;
- Figure 13 schematically depicts an example implementation of a first sub-step of method step 780 of the proposed method shown in Figure 7;
- Figure 14 schematically depicts an example implementation of a second sub-step of method step 780 of the proposed method shown in Figure 7;
- Figure 15 shows a flowchart of the proposed method of bonding a first substrate to a second substrate of the proposed method in accordance with a different embodiment; and
- Figure 16 schematically depicts an example implementation of method step 1510 of the proposed method shown in Figure 15.

### DETAILED DESCRIPTION

Before describing embodiments of the invention in detail, it is instructive to present an example environment in which embodiments of the present invention may be implemented.

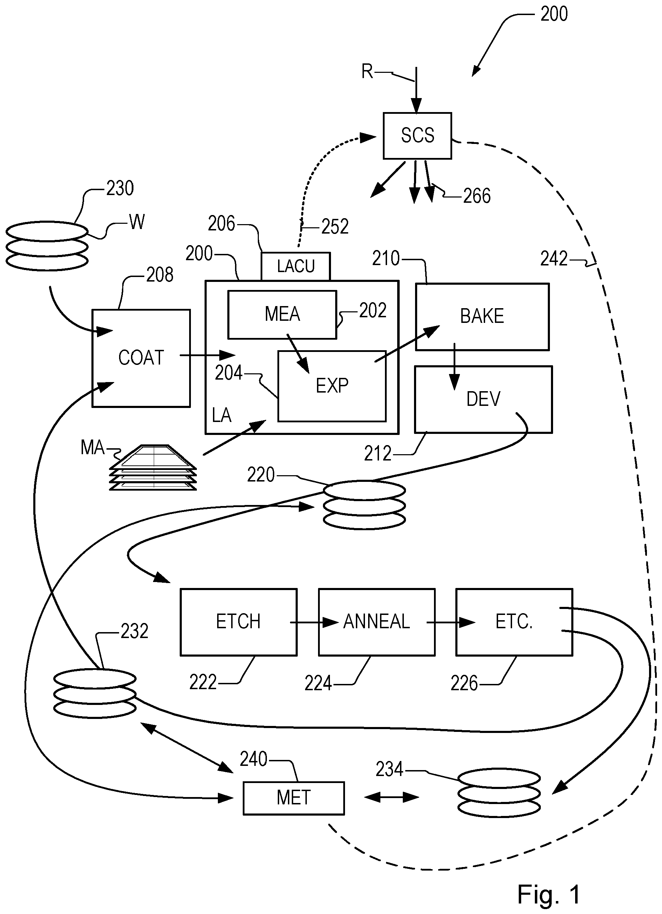

Figure 1 at 200 shows a lithographic apparatus LA as part of an industrial production facility implementing a high-volume, lithographic manufacturing process. In the present example, the manufacturing process is adapted for the manufacture of for semiconductor products (integrated circuits) on substrates such as semiconductor wafers. The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and substrate optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations.. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

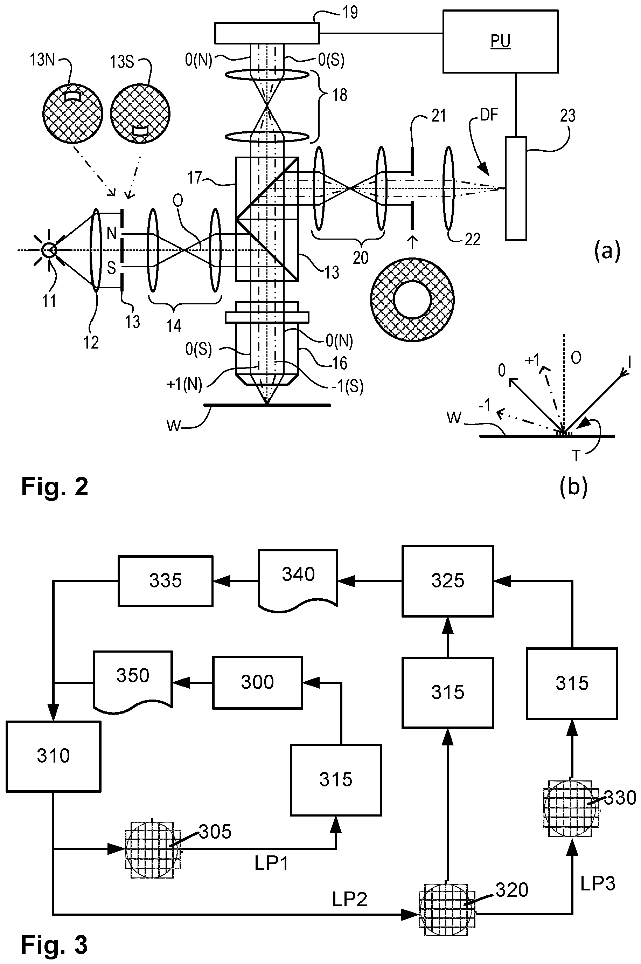

A metrology apparatus suitable for use in embodiments of the invention is shown in Figure 2(a). A target T and diffracted rays of measurement radiation used to illuminate the target are illustrated in more detail in Figure 2(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 2(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 2(a) and 2(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 2(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for many measurement purposes such as reconstruction used in methods described herein. The pupil plane image can also be used for focusing the metrology apparatus and/or normalizing intensity measurements of the first order beam.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 2 are purely examples. In another embodiment of the invention, on-axis illumination of the targets is used and an aperture stop with an off-axis aperture is used to pass substantially only one first order of diffracted light to the sensor. In yet other embodiments, 2^{nd}, 3^{rd} and higher order beams (not shown in Figure 2) can be used in measurements, instead of or in addition to the first order beams.

The target T may comprise a number of gratings, which may have differently biased overlay offsets in order to facilitate measurement of overlay between the layers in which the different parts of the composite gratings are formed. The gratings may also differ in their orientation, so as to diffract incoming radiation in X and Y directions. In one example, a target may comprise two X-direction gratings with biased overlay offsets +d and -d, and Y-direction gratings with biased overlay offsets +d and -d. Separate images of these gratings can be identified in the image captured by sensor 23. Once the separate images of the gratings have been identified, the intensities of those individual images can be measured, e.g., by averaging or summing selected pixel intensity values within the identified areas. Intensities and/or other properties of the images can be compared with one another. These results can be combined to measure different parameters of the lithographic process

Various techniques may be used to improve the accuracy of reproduction of patterns onto a substrate. Accurate reproduction of patterns onto a substrate is not the only concern in the production of ICs. Another concern is the yield, which generally measures how many functional devices a device manufacturer or a device manufacturing process can produce per substrate. Various approaches can be employed to enhance the yield. One such approach attempts to make the production of devices (e.g., imaging a portion of a design layout onto a substrate using a lithographic apparatus such as a scanner) more tolerant to perturbations of at least one of the processing parameters during processing a substrate, e.g., during imaging of a portion of a design layout onto a substrate using a lithographic apparatus. The concept of overlapping process window (OPW) is a useful tool for this approach. The production of devices (e.g., ICs) may include other steps such as substrate measurements before, after or during imaging, loading or unloading of the substrate, loading or unloading of a patterning device, positioning of a die underneath the projection optics before exposure, stepping from one die to another, etc. Further, various patterns on a patterning device may have different process windows (i.e., a space of processing parameters under which a pattern will be produced within specification). Examples of pattern specifications that relate to a potential systematic defect include checks for necking, line pull back, line thinning, CD, edge placement, overlapping, resist top loss, resist undercut and/or bridging. The process window of all or some (usually patterns within a particular area) of the patterns on a patterning device may be obtained by merging (e.g., overlapping) process windows of each individual pattern. The process window of these patterns is thus called an overlapping process window. The boundary of the OPW may contain boundaries of process windows of some of the individual patterns. In another words, these individual patterns limit the OPW. These individual patterns can be referred to as "hot spots" or "process window limiting patterns (PWLPs)," which are used interchangeably herein. When controlling a lithography process, it is possible, and typically economical, to focus on the hot spots. When the hot spots are not defective, it is likely that all the patterns are not defective. The imaging becomes more tolerant to perturbations when values of the processing parameters are closer to the OPW if the values of the processing parameters are outside the OPW, or when the values of the processing parameters are farther away from the boundary of the OPW if the values of the processing parameters are inside the OPW.

The values of the processing parameters may be selected such that they stay away from the boundary of the OPW or the fitted OPW, in order to decrease the chance that the processing parameters shift outside the OPW and thereby cause defects and decrease the yield. One approach of selecting the values of the processing parameters includes, before actual imaging, (1) optimizing the lithographic apparatus (e.g., optimizing the source and projection optics) and optimizing the design layout, (2) determining the OPW or fitted OPW (e.g., by simulation), and (3) determining a point in the space of the processing parameters (i.e., determining the values of the processing parameters) that is as far away as possible from the boundary of the OPW or fitted OPW (this point may be called the "center" of the OPW or fitted OPW).

During or before the actual imaging, the processing parameters may have a perturbation that causes them to deviate from the point that is as far away as possible from the boundary of the OPW or fitted OPW. For example, the focus may change due to topography of a substrate to be exposed, drift in the substrate stage, deformation of the projection optics, etc.; the dose may change to due drift in the source intensity, dwell time, etc. The perturbation may be large enough to cause processing parameters to be outside the OPW, and thus may lead to defects. Various techniques may be used to identify a processing parameter that is perturbed and to correct that processing parameter. For example, if the focus is perturbed, e.g., because an area of the substrate that is slightly raised from the rest of the substrate is being exposed, the substrate stage may be moved or tilted to compensate for the perturbation.

Control of the lithographic process are typically based on measurements fed back or fed forward and then modelled using, for example interfield (across-substrate fingerprint) or intrafield (across-field fingerprint) models. Within a die, there may be separate functional areas such as memory areas, logic areas, contact areas etc. Each different functional area, or different functional area type may have a different process window, each with a different processes window center. For example, different functional area types may have different heights, and therefore different best focus settings. Also, different functional area types may have different structure complexities and therefore different focus tolerances (focus process windows) around each best focus. However, each of these different functional areas will typically be formed using the same focus (or dose or position etc.) setting due to control grid resolution limitations.

Figure 3 depicts the overall lithography and metrology method incorporating a stability module 300 (essentially an application running on a server, in this example). Shown are three main process control loops, labeled LP1, LP2, LP3. The first loop LP1 provides recurrent monitoring for stability control of the lithography apparatus using the stability module 300 and monitor wafers. Immediately after a lithographic apparatus calibration, a baseline wafer or wafer set is exposed on the lithographic apparatus or scanner 310 and measured by a metrology tool 315 to set baseline parameters e.g., for focus and/or overlay (e.g., the scanner's overlay and/or focus baseline fingerprints). At a later time (e.g., periodically), a monitor wafer 305 is exposed on scanner 310 and measured by metrology tool 315. The stability module 300 compares the parameters from the monitor wafer 305 measurements (e.g., the scanner's present overlay and/or focus fingerprints) and compares these to the (stored) baseline parameters. Based on the comparison, stability module 300 calculates correction routines 350 to correct for drift in these parameters which is fed back to the scanner 310 and used when performing further exposures. This can be repeated periodically to control scanner drift, e.g., to determine corrections which return the scanner operation to (or near) the baseline parameters. The exposure of the monitor wafer may involve printing a pattern of marks on top of reference marks. By measuring overlay error between the top and bottom marks, deviations in performance of the lithographic apparatus can be measured, even when the wafers have been removed from the apparatus and placed in the metrology tool. Such monitor wafer may also comprise focus marks for monitoring of focus.

In some embodiments, the monitor wafers are dedicated to a particular lithographic apparatus. In other embodiments, a "golden reference" baseline monitor wafer is defined which can be used for all lithographic apparatuses, along with an associated difference set to adapt the baseline parameters for each individual lithographic apparatus. The stability module 300 calculates the difference (as a difference set or correction set) between the golden reference wafer and a standard monitor wafer exposed on each scanner. The standard monitor wafer plus the difference set acts as a new copy of the reference. In this manner, every scanner in a fabrication site (fab), regardless of scanner type or model and of grid differences, can be matched to this golden reference, increasing fab efficiency significantly.

The second (APC) loop is for local scanner control on-product (determining focus, dose, and overlay on product wafers). The exposed product wafer 320 is passed to metrology unit 315 where information relating for example to parameters such as critical dimension, sidewall angles and overlay is determined and passed onto the Advanced Process Control (APC) module 325. This data is also passed to the stability module 300. Process corrections 340 are made before the Manufacturing Execution System (MES) 335 takes over, providing control of the scanner 310, in communication with the scanner stability module 300.

The third control loop is to allow metrology integration into the second (APC) loop (e.g., for double patterning). The post etched wafer 330 is passed to metrology unit 315 which again measures parameters such as critical dimensions, sidewall angles and overlay, read from the wafer. These parameters are passed to the Advanced Process Control (APC) module 325. The loop continues the same as with the second loop.

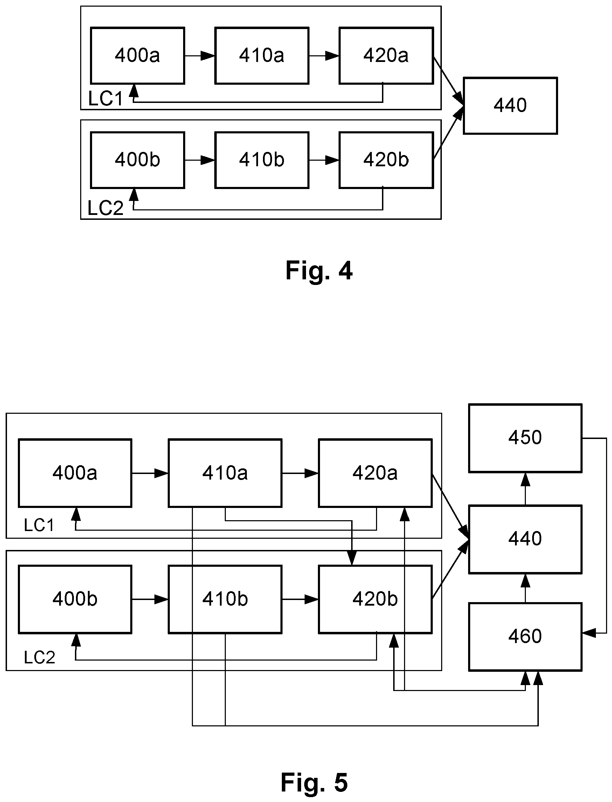

Figure 4 shows a device manufacturing arrangement for making bonded substrates (and therefore ICs based on bonded substrates) comprising a first manufacturing lithocell LC1 and a second manufacturing lithocell LC2. Within each lithocell is a pair of lithographic processing systems 400a, 400b and first metrology systems 410a, 410b. The lithographic processing system 400a, 400b, may comprise a full patterning system. Such a system may comprise, for example, an optical lithographic apparatus or scanner such as described in respect of Figure 1, a track tool, a deposition tool, an etch tool, any other apparatus used in the patterning process, or any combination selected therefrom. The systems may also each comprise a software application 420a, 420b in communication with its respective lithographic processing system 400a, 400b and metrology system 410a, 410b, so that results, designs, data, etc. of the lithographic processing system 400a, 400b and/or the metrology apparatus 410a, 410b may be stored and analyzed by the software application 420a, 420b at the same time or different times.

Once pairs of substrates or wafers are completed from each of lithocell LC 1 and lithocell LC2, they may be bonded within a bonding tool 440 to obtain a bonded wafer. Bonding in this context is wafer-to-wafer bonding where whole wafers are aligned and bonded together such that individual dies on each wafer are aligned. The concept of wafer-to-wafer bonding is known and used in many IC manufacturing processes. The bonding tool 440 may comprise a bonding alignment device for aligning the wafers together for bonding. For example, the bonding tool 440 may perform pre-align using box-in-box marks provided to wafers (e.g., one box on each wafer), with visual inspection of marks used for alignment quality/ position control. Another method uses two imaging sensors (e.g., face to face) which are first calibrated together to find their relative positions; each sensor is then used to separately align a respective wafer to be bonded.

Lithocell LC1 and lithocell LC2 may be the same lithocell, different lithocells but comprising one or more shared tools and elements, or be completely different lithocells having completely different sets of apparatuses and tools, possibly even at different sites or fabs. For example, one or more of the tools or apparatuses of the lithographic processing systems 400a and 400b may comprise different tools or the same tools within each respective system. Similarly metrology apparatuses 410 and 410b may be the same apparatus or different apparatuses. The software application 420a, 420b may be comprised within one or both of the respective lithographic processing systems 400a, 400b and/or one or both of the first metrology systems 410a, 410b, or elsewhere.

As mentioned above, the lithographic processing system 400a, 400b may be configured to include the lithographic apparatus LA in Figure 1. The lithographic processing system 400a, 400b may be setup for executing the patterning aspect of the patterning process and optionally, may be configured to correct for deviations occurring within the lithographic processing system 400a, 400b or in one or more other processes or apparatuses in the patterning process. The lithographic processing system 400a, 400b may be able to apply a correction of an error (e.g., imaging error, focus error, dose error, etc.) by adjusting one or more modification apparatuses of the lithographic processing system 400a, 400b. That is, correction may be made by any manufacturing processing tool in the lithographic processing system 400a, 400b that can purposefully modify a patterning error. In present systems, however, these corrections (scanner corrections and other processing tool corrections) do not take into account any of the bonding processes performed by the bonding tool 440.

For example, the correction of an error can be made by adjusting one or more modification apparatuses of the lithographic apparatus, e.g., by employing the adjustment mechanism AM to correct for or apply an optical aberration, by employing the adjuster AD to correct or modify an illumination intensity distribution, by employing the positioner PM of the patterning device support structure MT and/or the positioner PW of the wafer table WT to correct or modify the position of the patterning device support structure MT and/or the wafer table WT respectively, etc. Where, for example, the lithographic processing system 400a, 400b comprises a track tool, correction of an error can be made by adjusting one or more modification apparatuses of the track tool, e.g., modifying a bake temperature of a bake tool of the track, modifying a development parameter of a development tool of the track, etc. Similarly, where, for example, the lithographic processing system 400a, 400b comprises an etch tool, correction of an error can be made by adjusting one or more modification apparatuses of the etch tool, e.g., modifying an etch parameter, such as etchant type, etchant rate, etc. Similarly, where, for example, the lithographic processing system 400a, 400b comprises a planarization tool, correction of an error can be made by adjusting one or more modification apparatuses of the planarization tool, e.g., modifying a planarization parameter. Similarly, where, for example, the lithographic processing system 400a, 400b comprises a deposition tool, correction of an error can be made by adjusting one or more modification apparatuses of the deposition tool, e.g., modifying a deposition parameter.

One or more modification apparatuses of the lithographic processing system 400a, 400b may be able to apply up to third order polynomial correction of errors (e.g., imaging error, focus error, dose error, etc.).

The metrology apparatus 410a, 410b may be configured to obtain measurements related to wafers printed with patterns by the lithographic processing system 400a, 400b. The metrology apparatus 410a, 410b may be configured to measure or determine one or more parameters (e.g., overlay error, dose, focus, CD, etc.) of the patterns printed by the lithographic processing system 400a, 400b. The metrology apparatus 410a, 410b may be a diffraction-based overlay metrology tool that can measure, e.g., overlay, critical dimension and/or other parameters. The metrology apparatus 410a, 410b may be an alignment apparatus used to measure relative position between two objects, such as between a patterning device and a wafer. The metrology apparatus 410a, 410b may be a level sensor to measure a position of a surface, e.g., a height and/or rotational position of a wafer surface. The metrology apparatus 410a, 410b may be a plurality of metrology apparatuses including any combination of these devices.

The metrology apparatus 410a, 410b may measure and/or determine one or more values of one or more parameters (e.g., overlay error, CD, focus, dose, etc.) associated with an error in the patterning process. After the metrology apparatus 410a, 410b finishes the measurement or determination, the software application 420a, 420b creates modification information based on the measurement data (e.g., overlay error, CD, focus, dose, etc.). The software application 420a, 420b may evaluate the one or more values of the one or more parameters to determine if they are within a tolerance range. If not, the software application 420a, 420b determines modification information to correct an error reflected by the out of tolerance one or more values of the one or more parameters. The software application 420a, 420b may use one or more mathematical models to determine error correctable by one or more modification apparatuses of the lithographic processing system 400a, 400b and to provide information for one or more parameters (e.g. modification information) of the one or more modification apparatuses of the lithographic processing system 400a, 400b, which one or more parameters enable configuration of the one or more modification apparatuses of the lithographic processing system 400a, 400b to correct (e.g., eliminate or reduce to within a tolerance range) the error. One or more of the mathematical models may define a set of basis functions that fit the data once parameterized. The one or more mathematical models may comprise a model configured to simulate correctable error for the lithographic processing system 400a, 400b. The model may specify a range of modifications that one or more of the modification apparatuses of the lithographic processing system 400a, 400b can make and determines correctable error within the range. That is, the range may specify an upper limit, a lower limit, and/or both on the amount of modifications that a particular modification apparatus of the lithographic processing system 400a, 400b can make.

There are a number of drawbacks with the method described in relation to Figure 4. Such scanner control methods are unaware of, and therefore do not take into account of, potential bonding steps with other wafers. Wafers may be bonded together which have incompatible or poorly optimized grids / shapes / dead die locations. For example, a first wafer may have a bowl shaped fingerprint with dead (or out of spec) dies being found at the edge and a second wafer may have a fingerprint with the inverse bowl shape such that dead dies are found near the center. Bonding of these wafers would be sub-optimal and wasteful compared to bonding wafers which have similar fingerprints. For bonding use cases a wafer may be paired with another wafer having a specific grid which is not necessarily matched to the grid of the current wafer.

A number of methods will now be described to improve upon the manufacturing techniques which use wafer-to-wafer bonding of two or more wafers together. The methods comprise the following:
- Overlay feedforward correction of a bonding fingerprint induced by wafer bonding-process;
- Co-optimization of correction capabilities of scanner and wafer bonder control capabilities;
- Application of reference scanner monitoring wafer to enable grid matching of to-be-bonded wafers;

Figure 5 is a flow diagram which illustrates examples of these concepts in a single flow. However, it should be appreciated that all these concepts can be implemented individually, and/or a method disclosed herein may comprise any two or more in any combination. Each concept will now be described individually. The flow diagram of Figure 5 is based upon that of Figure 4, and the same elements have the same labels and therefore will not be necessarily described further. As represented in Figure 5, the bonding apparatus 440 may have an associated bonding metrology tool 450 and bonding software application 460. As before, the bonding metrology tool 450 may be separate to the other metrology tools in the Figure, or it may be that the same metrology tool is represented by any two or all three of metrology tools 450, 410a, 410b. Similarly, the software application 460 may be the same (or run on the same apparatus) as one or both of software applications 420a, 420b, and may be run on any of the apparatuses represented in the Figure, and/or one or more separate processing apparatuses (not shown). Also note that the description below describes the bonding process as that bonding two wafers. However, the concepts are equally applicable to bonding of more than two wafers, and as such any reference to terms such as "wafer pair" is to be understood to encompass sets of wafers greater than 2, which are to be bonded together.

As with Figure 4, lithocell LC1 and lithocell LC2 may be the same lithocell, different lithocells but comprising one or more shared tools and elements, or be completely different lithocells having completely different sets of apparatuses and tools, possibly even at different sites or fabs.

### Overlay feedforward correction of a bonding fingerprint induced by wafer bonding-process

In this concept, it is proposed to measure the across wafer parameter (e.g., overlay) fingerprint after bonding, and using this fingerprint as an input for determining a correction or optimization for the bonding process for bonding of subsequent wafers. For example, after bonding of first and second wafers W1, W2, the fingerprint may be measured by metrology tool 450 and a correction or bonding optimization determined by software application 460 for bonding third and fourth wafers W3 and W4. The correction may be determined based also on the individual fingerprints of each wafer (e.g., as measured by metrology tools 410a, 410b), such that software application deduces the bonding tool fingerprint contribution from the final bonded fingerprint and the two pre-bonding wafer fingerprints. The software application 460 can then actively actuate (e.g., via a correction and/or optimization) the bonding tool 440 to optimize overlay for bonding the next wafer pair. Therefore, this concept may be represented in Figure 5, by the loop of elements 440, 450, 460 and the feedforward of data from metrology devices 410a, 410b to software application 460.

In an example, this concept may be implemented within and by the APC control loop (e.g., loop LP2 of Figure 3). In an example, the feedforward may be more comprehensive (e.g. via APC controller or otherwise) by taking a larger set of historic overlay data (pre-bonding and post-bonding fingerprints) into account; e.g., to prevent unstable control (for example, where the fingerprint data for an immediately preceding wafer pair is non-representative of the process generally).

### Co-optimization of correction capabilities of scanner and wafer bonder control capabilities

Based on knowledge of the bonding tool fingerprint (e.g., using methods described above) co-optimized corrections for the bonding tool fingerprint and one or both of the scanner fingerprints can be determined. The co-optimization may therefore determine co-optimized corrections for one or both exposure processes for each wafer pair to be bonded and for the bonding process, which together minimize overlay in the final bonded wafer. The co-optimization may also include corrections for other tools, such as an etching tool (which also induces its own fingerprint contribution). It can be appreciated, for example, that such a co-optimization method may actually worsen overlay (or even dies-in-spec) for one or both of the unbonded wafers, but in a manner which minimizes overlay across the bonded wafer and/or maximizes dies-in spec of the bonded wafer. Any co-optimization strategy may be used, including a die-in-spec co-optimization, a max-abs optimization, a least-squares co-optimization or any other suitable optimization. Co-optimization concepts are described, for example, in US2018/0252998 and WO2019/110261 both of which are incorporated herein by reference. Any of the co-optimization concepts described herein, but extended to the bonding process is envisaged in this concept.

For example, the co-optimization may comprise controlling the bonding tool and one or both scanner fingerprints such that the scanner corrections pre-correct for the bonding tool contribution to the overall bonded wafer overlay fingerprint. For example, such an optimization may comprise finding scanner and/or bonding tool (and/or etch tool or other tool) corrections which minimize the difference between the second wafer (pre-bonding) fingerprint and the sum of the first wafer (pre-bonding) fingerprint and the bonding tool fingerprint (for a to-be-bonded wafer pair of said first wafer and second wafer). The co-optimization may also include co-optimizing a patterning device or reticle pattern (e.g., via a reticle patterning apparatus) used for patterning the first and/or second wafer.

Such a co-optimization may be based on the correction capabilities of the relevant tools (e.g., scanners, bonding tool and/or etch tool), so as to distribute the correction across these tools to achieve lowest non-correctable error (NCE) for the parameter of interest (e.g., overlay); e.g., using a pattern fidelity control (PFC) type approach. This distribution between scanner and bonder (and possible other tool) correction capabilities can be based, not only on the type of correction capability (e.g., per spatial frequency, order, field), but also on the range of this correction capability. By way of specific example, by adding an offset to the scanner actuation, the resulting fingerprint can be brought closer to the center of the correction range of the bonding tool (or *vice versa).* Such concepts are described, for example in the aforementioned US2018/0252998.

In such an example, the co-optimization may comprise (e.g., using one or more mathematical models) determining an error correctable by one or more apparatuses of the lithographic processing systems 400a, 400b and/or the bonding tool 440, and adding an offset (e.g., deliberate error) to one of the processes performed by one of these apparatuses (or to the reticle pattern itself). For example, the offset may result in a transformation of a non-correctable error by an apparatus of the lithographic processing systems 400a, 400b or bonding tool 440 to a correctable error by one or more other apparatuses of the lithographic processing systems 400a, 400b, the bonding tool 440 and/or the reticle pattern. As an example of such transformation, an error having an uncorrectable spatial resolution for a particular apparatus of one or both lithographic processing systems 400a, 400b and/or bonding tool 440 can be enabled for correction by adding further error such that the total error has a spatial resolution correctable by the apparatus of one or both lithographic processing systems 400a, 400b and/or bonding tool 440. In an example, the added error may be divided among a plurality of the relevant apparatuses and/or the reticle pattern (e.g., via a reticle modification tool).

The co-optimization may further comprise determining a control recipe for one or both of the first lithographic processing system 400a and lithographic processing system 400b from a first control grid (e.g., measured using a scatterometer and/or alignment sensor) associated with the first lithographic processing system 400a and a second control grid (e.g., measured using a scatterometer and/or alignment sensor) associated with the second lithographic processing system 400b so as to optimize matching of first control grid and second control grid.

### Reference scanner monitoring wafer to enable grid matching of to-be-bonded wafers

The concept of scanner stability monitoring using monitor wafers was described above in combination with Figure 3 (loop LP1). It is proposed that similar methods be used to match the control grids for each wafer of a wafer pair (or larger wafer set). As already stated, the first and second wafers may come from different scanners 400a, 400b. These different scanners may be located within different fabs and may comprise completely different systems or platforms (e.g., one might be an EUV scanner and another may be a DUV scanner). As such, the scanners may comprise completely different control and alignment strategies and therefore may have different, incompatible, control grid definitions. While this scanner grid difference may be budgeted for the overall overlay budget of the bonded wafers, its impact may be reduced or minimized by using a common grid definition.

In a first implementation, this may be achieved by using matched or copied monitor wafers such as those already described. A suitable processing module (e.g. a module such as stability module 300, which may be represented in Figure 5 by software application 460) may calculate the difference (as a difference set or correction set) between a golden reference wafer and a standard monitor wafer exposed on each scanner. The respective monitor wafers plus the difference sets will be matched, so as to define a common grid which may be used as the control grid for the bonding process by bonding tool 440.

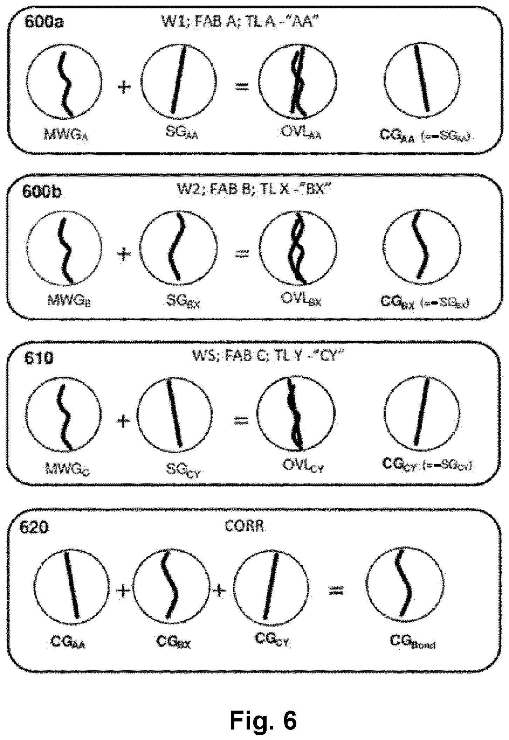

Figure 6 illustrates a flow for a further implementation for determining a post-bonding lithography correction of a grid delta (grid difference) between the grids of the bonded wafers using the delta of monitor wafer grids. After bonding and grinding / thinning the top silicon substrate, the post-bonding lithography layers may be a target for overlay improvement. Such a method controls delta / drift of grids in wafer stack by controlling them with respect to a monitor wafer grid. The method assumes that there is a single set of matched monitor wafers for each fab or scanner involved in manufacturing a wafer for the wafer stack and for the post bonding lithography. Alternatively, if this is not possible or feasible, a calculated delta grid (correction set) between the monitor wafers can be added to the process flow (e.g., at step 620 of the illustrated flow).

Step 600a relates to a first fab, FAB A comprising a first scanner, TL A on which a first wafer W1 is to be processed. A monitor wafer (e.g., from the matched set) has had a monitor wafer grid MWG_{A} exposed thereon. Following this, the scanner TL A is used in to perform a lithography step on the monitor wafer, imposing thereon its respective scanner grid SG_{AA}. The monitor wafer is then measured to obtain the overlay fingerprint OVL_{AA} resultant from both grids. Based on this a correction grid is CG_{AA} is determined (e.g., as the inverse of the scanner grid SG_{AA}).

Step 600b relates to a second fab, FAB B comprising a second scanner, TL X on which a second wafer W2 is to be processed. A monitor wafer (e.g., from the matched set) has had a monitor wafer grid MWG_{B} exposed thereon. Following this, the scanner TL X is used in to perform a lithography step on the monitor wafer, imposing thereon its respective scanner grid SG_{BX}. The monitor wafer is then measured to obtain the overlay fingerprint OVL_{BX} resultant from both grids. Based on this a correction grid is CG_{BX} is determined (e.g., as the inverse of the scanner grid SG_{BX}).

Step 610 relates to a third fab, FAB C comprising a third scanner, TL Y on which the wafer stack WS comprising bonded wafer pair W1, W2 is to be processed in a post-bonding lithography step. A monitor wafer (e.g., from the matched set) has had a monitor wafer grid MWGc exposed thereon. Following this, the scanner TL C is used in to perform a lithography step on the monitor wafer, imposing thereon its respective scanner grid SG_{CY}.The monitor wafer is then measured to obtain the overlay fingerprint OVL_{CY} resultant from both grids. Based on this a correction grid is CG_{CY} is determined (e.g., as the inverse of the scanner grid SG_{CY}).

At step 620, a bonding scanner correction grid CG_{Bond} is determined from the correction grids CG_{AA}, CG_{BX}, CG_{CY}, as determined in the previous steps. For example, the bonding scanner correction grid CG_{Bond} may be determined as a combination (e.g., the sum) of the correction grids CG_{AA}, CG_{BX}, CG_{CY} Therefore the bonding scanner correction grid CG_{Bond} may be determined as a combination (e.g., the sum) of the inverses of the related scanner grids (e.g. a combination of -SG_{AA}, -SG_{BX}, -SG_{CY}). The bonding scanner correction grid CG_{Bond} may also include contributions from one or more calculated delta grids for respective correction grids where no suitably matched monitor wafer was used in determining the correction grid. The bonding scanner correction grid CG_{Bond} may be applied when processing the wafer stack at third fab FAB C, when using scanner TL Y for post-bonding lithography. This may be accomplished by adding it to the stability module control loop at the third fab FAB C or via an external interface (e.g., controlled by a user at the third fab).

In this manner scanner grid drift (for scanners TL A, TL X, TL Y) is taken into account by updating the bonding scanner correction grid CG_{Bond} at the same frequency as the scanner correction grids in each separate Fabs (e.g., every few days). It will be readily appreciated that this method can be extended to post-bonding lithography steps on bonded stacks comprising more than two wafers.

While the above-described methods have been successfully implemented to improve the performance of the wafer-to-wafer bonding process, these methods may not be able to meet the increasingly stringent requirements for the precision of wafer-to-wafer or die-to-wafer bonding, in particular high precision hybrid bonding (e.g., transistor-level bonding) where a bonding overlay of less than 2 nm is needed. Therefore, it is desirable to have a method and apparatus capable of further improving the bonding precision.

Accordingly, one aspect of the present disclosure provides a method of bonding a first substrate to a second substrate, the first substrate comprising a first bonding surface and a plurality of first electrically conductive pads protruding from, or levelled with, or recessed from the first bonding surface and the second substrate comprising a second bonding surface and a plurality of second electrically conductive pads protruding from, or levelled with, or recessed from the second bonding surface, the method comprising: reducing a distance between the first bonding surface and the second bonding surface; selectively depositing a dielectric layer onto the first bonding surface and/or the second bonding surface to fill a gap therebetween; and bringing each of the first electrically conductive pads into electrical contact with a respective one of the second electrically conductive pads. The electrical contact between the first electrically conductive pads and the second electrically conductive pads may be achieved either during the substrate bonding process and/or during a post-bonding high temperature treatment of the bonded substrate through heat-induced metal expansion and diffusion. The proposed method may allow a larger degree of control of the first and second substrates in-plane and/or lateral deformation prior to bonding and so may allow to better match grids of the first and second substrates, compared to a conventional optical or hybrid bonding sequences.

In an embodiment, the first substrate may comprise a first top dielectric layer comprising the first bonding surface and the second substrate may comprise a second top dielectric layer comprising the second bonding surface. The first top dielectric layer and the second top dielectric layer may be composed of a dielectric material (e.g., SiO₂) that may or may not be the same as the dielectric layer selectively deposited between the first bonding surface and the second bonding surface. The selectively deposited dielectric layer may be composed of for example Tantalum oxide (TazOs).

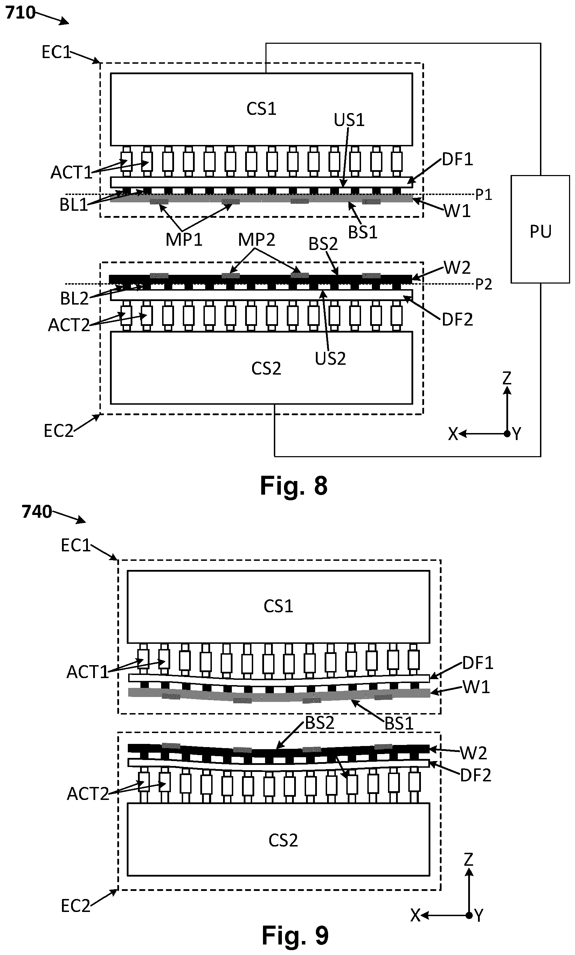

In an embodiment, the dielectric layer may be selectively deposited onto the first bonding surface and/or the second bonding surface using a redox-coupled inherently selective atomic layer deposition (ALD) technique. With the help of the redox-coupled inherently selective ALD, dielectric (e.g., TazOs) thin films can be deposited only on dielectric oxides but not on metals (e.g., copper). Such a selective deposition is achieved through using 'reduction-absorption-oxidation' ALD cycles which are designed by adding an in-situ reduction step, effectively inhibiting nucleation on metals (e.g., copper). The deposition of the dielectric layer may be performed within a substrate bonding apparatus (see Figure 8). In such a case, the substrate bonding apparatus may comprise an ALD reactor which may be in the form of a sub-module and which may be configured for depositing the dielectric layer. The bonding of the first substrate and the second substrate may be performed within such an ALD reactor. Additionally, the substrate bonding apparatus may comprise a heating apparatus or sub-module (e.g., an oven) configured to heat up a bonded substrate so as to increase or establish electrical contact between the plurality of first electrically conductive pads and the plurality of second electrically conductive pads through heat-induced expansion and diffusion. Further information about the redox-coupled inherently selective ALD can be found in the scientific publication Yicheng Li, Zilian Qi, Yuxiao Lan, Kun Cao , Yanwei Wen, Jingming Zhang, Eryan Gu, Junzhou Long, Jin Yan, Bin Shan & Rong Chen "Self-aligned patterning of tantalum oxide on Cu/SiO2 through redox-coupled inherently selective atomic layer deposition," Nature Communications, (2023) 14:4493, which is incorporated herein by reference.

In an embodiment, the plurality of first electrically conductive pads may be a plurality of first metal pads and/or the plurality of second electrically conductive pads may be a plurality of second metal pads. In an embodiment, the plurality of first metal pads of the first substrate and/or the plurality of second metal pads of the second substrate may be formed by damascene processing. The shift from aluminium/SiO₂ to Cu-low k has resulted in an alternative to the conventional thin film deposition, resist pattern application, and etching process sequence. This new process sequence is called damascene processing. In this process sequence the dielectric is deposited first, and the areas where copper conductors are desired are removed by the conventional resist application and etch process. This leaves the dielectric with trenches in a pattern desired for the copper metallization. The thick layer of copper metal is deposited to fill the trenched areas as well as depositing over the surface of the dielectric. The entire surface of the wafer is then polished by a chemical-mechanical polishing process (called CMP) to remove the surface layer of copper, leaving the desired conducting wires only in the trench regions, separated by the low-k dielectric insulator. Further information about damascene processing can be found in "Chapter 20 - Integrated Circuits" of the book "Reference Data for Engineers (Ninth Edition)", by Pallab K. Chatterjee, Satwinder D.S. Malhi, Michiel deWit, Harold Hosack, Mark G. Harward, Mehrdad M. Moslehi, pages 20-1 to 20-113, 2002, which is incorporated herein by reference. In an alternative embodiment, the plurality of first metal pads of the first substrate and/or the plurality of the second metal pads of the second substrate may be formed by direct metal etching. Both damascene processing and direct metal etching are commonly used techniques in semiconductor manufacturing.

In an embodiment, prior to the reducing step, the method may further comprise bending a first region (e.g., a central region) of the first bonding surface of the first substrate towards the second substrate and a second region (e.g., a central region) of the second bonding surface of the second substrate towards the first substrate, respectively. The gap between the first bonding surface and the second bonding surface may have a minimum between the first region of the first bonding surface and the second region of the second bonding surface. The minimum gap may be flexibly set depending on the deposition technique (e.g., the redox-coupled inherently selective ALD) adopted to deposit the dielectric layer. While the depositing step is being performed, the method may further comprise gradually releasing the bending of the first region of the first bonding surface and the bending of the second region of the second bonding surface until the gap is completely filled.

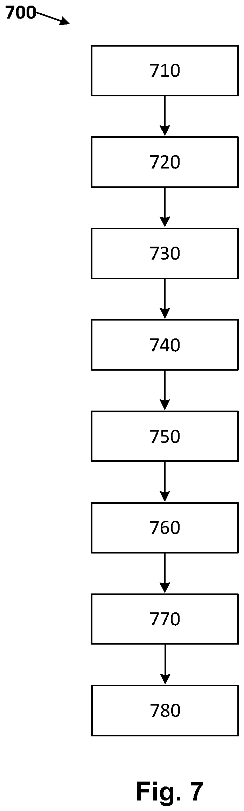

Figure 7 shows a flowchart of the proposed method of bonding a first substrate to a second substrate in accordance with an embodiment. In this embodiment, the method 700 comprises eight main steps, i.e. steps 710 to 780. Figure 8 schematically depicts an example substrate bonding apparatus that is suitable for implementing the method 700. Also shown are a side cross-sectional view of a first (top) substrate clamp EC1 (excluding the first substrate W1) and a side cross-sectional view of a second (bottom) substrate clamp EC2 (excluding the second substrate W2) comprised within the substrate bonding apparatus. Figures 9 to 13 schematically depict example implementations of the respective method steps 740 to 780.

For the sake of simplicity, only some of the components or modules of the substrate bonding apparatus are shown in Figures 8 to 13. The first substrate clamp EC1 and the second substrate clamp EC2 may be comprised in an ALD reactor (which is not shown in those figures) within which the dielectric layer may be deposited onto the first bonding surface of the first substrate and the second bonding surface of the second substrate to fill a gap therebetween and the plurality of the first electrically conductive pads and the plurality of the second electrically conductive pads may be heated up such that each of the plurality of first electrically conductive pads is connectable with a respective one of the second electrically conductive pads as a result of heat-induced expansion and diffusion.

With reference to Figures 7 and 8, at method step 710, a first substrate W1 and a second substrate W2 are placed onto a first substrate clamp EC1 and a second substrate clamp EC2, respectively. The first substrate W1 comprises a first bonding surface BS1 and a plurality of first metal pads MP1 protruding from the first bonding surface BS1. The second substrate W2 comprises a second bonding surface BS2 to be bonded to the first bonding surface BS2 and a plurality of second metal pads MP2 protruding from the second bonding surface BS2. In other embodiments, the first electrically conductive pads MP1 may be levelled with or recessed from the first bonding surface BS1 and/or the second electrically conductive pads MP2 may be levelled with or recessed from the second bonding surface BS2. Optionally or in addition, the first electrically conductive pads and the second electrically conductive pads may be composed of one or more non-metal materials. Both the first substrate W1 and the second substrate W2 may be a semiconductor wafer. The first substrate clamp EC1 is configured to securely hold the first substrate W1 and impose a first deformation to the first bonding surface BS1 of the first substrate W1. The second substrate clamp EC2 is configured to securely hold the second substrate W2 and impose a second deformation to the second bonding surface BS2 of the second substrate W2. The clamping of any one of the substrates W1 or W2 may be based on substrate polarization, for example by electrostatic clamp, or by gas pressure acting on substrate, for example by vacuum clamp.

In the example setup shown in Figure 8, the top substrate clamp EC1 comprises a plurality of first actuators ACT1 which are embedded within a body of the top substrate clamp EC1 and the bottom substrate clamp EC2 comprises a plurality of second actuators ACT1 which are embedded within a body of the bottom substrate clamp EC1. The plurality of first actuators ACT1 and the plurality of second actuators ACT2 may be operable to displace along at least a direction (e.g., along the Z-axis according to the local coordinate system shown in Figure 8) perpendicular to a transversal plane P1 or P2 (e.g., the X-Y plane according to the local coordinate system shown in Figure 8) in which the first substrate W1 or the second substrate W2 is held. The plurality of first actuators ACT1 and/or the plurality of second actuators ACT2 may be piezo actuators. Alternatively, the actuators ACT1 or ACT2 may be hydraulic, or magnetic, or electrostatic based.

The top substrate clamp EC1 further comprises a first clamp support CS1, a first deformable layer DF1 which comprises a first upper surface US1 (or the surface facing the first substrate W1) and a plurality of first burls BL1 arranged on the first upper surface US1. The plurality of first burls BL1 are configured to be in direct contact with (a lower surface (or the surface facing the first clamp support CS1) of) the first substrate W1. The plurality of first actuators ACT1 are sandwiched between the first clamp support CS1 and the first deformable layer DF1. Each of the first actuators ACT1 may comprise a stationary section (not shown) and a moveable section (not shown) respectively fixed to the first clamp support CS1 and the first deformable layer DF1. The first deformable layer DF1 of the top substrate clamp EC1 may comprise a plurality of embedded electrodes (not shown) configured to apply a substrate force for securely holding the first substrate W1. The first substrate clamp EC1 as described above is also known as an electrostatic wafer clamp or active wafer clamp.

In operation, displacements of one or more of the first actuators ACT1 of the top substrate clamp EC1 may cause the first deformable layer DF1 to deform in a controlled manner. The deformation of the first deformable layer DF1 may in turn result in a deformation of the first bonding surface BS1 of the first substrate W1. The deformation imposed onto the first bonding surface BS1 by the first deformable layer DF1 may be substantially identical to the deformation imposed onto the first deformable layer DF1 by the displacements of one or more of the first actuators ACT1.

Similar to the top substrate clamp EC1, the bottom substrate clamp EC2 comprises a second clamp support CS2, a second deformable layer DF2 which comprises a second upper surface US2 (or the surface facing the second substrate W2) and a plurality of second burls BL2 arranged on the second upper surface US2. The second burls BL2 are configured to be in direct contact with (a lower surface or the surface facing the second clamp support CS2 of) the second substrate W2. The plurality of second actuators ACT2 are sandwiched between the second clamp support CS2 and the second deformable layer DF2. Each of the second actuators ACT2 may comprise a stationary section (not shown) and a moveable section (not shown) respectively fixed to the second clamp support CS2 and the second deformable layer DF2. The second deformable layer DF2 of the bottom substrate clamp EC2 may comprise a plurality of embedded electrodes (not shown) configured to apply a substrate force for securely holding the second substrate W2.

In operation, displacements of one or more of the second actuators ACT2 of the bottom substrate clamp EC2 may cause the second deformable layer DF2 to deform in a controlled manner. The deformation of the second deformable layer DF2 may in turn result in a deformation of the second bonding surface BS2 of the second substrate W2. The deformation imposed onto the second bonding surface BS2 by the second deformable layer DF2 may be substantially identical to the deformation imposed onto the second deformable layer DF2 by the displacements of one or more of the second actuators ACT2. The arrangement (e.g., the distribution and the control) of the second actuators ACT2 of the second substrate clamp EC2 may be same or similar to the arrangement of the first actuators ACT1 of the first substrate clamp EC1.

Further information about the top electrostatic clamp EC1 or the bottom electrostatic clamp EC2 can be found in the published PhD Thesis: Steur, M. M. A., "Design of an active wafer clamp for wafer machines", Technische Universiteit Eindhoven, 2017, which is incorporated herein by reference. It will be appreciated that other configurations of active electrostatic or vacuum clamps may be equally suitable for use in the substrate bonding apparatus 700 as long as they can securely hold a substrate (e.g., a wafer) and impose a controllable deformation onto a bonding surface of the substrate.

With continued reference to Figure 8, the substrate bonding apparatus further comprises a processing unit PU (e.g. a module such as stability module 300, which may be represented in Figure 5 by software application 460) which is connected to both the top substrate clamp EC1 and the second substrate clamp EC2. The processing unit PU may be a computing device comprised within the substrate bonding apparatus. In a different embodiment, the processing unit PU may be external to the substrate bonding apparatus. The external processing unit may comprise cloud-based computing resources. In another different embodiment, the processing unit may be formed by a combination of internal and external computing devices.

At method step 720, the first substrate W1 and the second substrate W2 are measured to obtain a first set of measurement data and a second set of measurement data, respectively. The measurements may be conducted by at least one metrology sensor (e.g., the bonding metrology tool 450 shown in Figure 5) either comprised within or external to the substrate bonding apparatus shown in Figure 8. The at least one metrology sensor may comprise an alignment sensor and/or a level sensor (e.g., as described above).

At method step 730, the first set of measurement data is used to determine the first deformation and the second set of measurement data is used to determine the second deformation. The method step 730 may be performed by the processing unit PU of the substrate bonding apparatus shown in Figure 8. In an example implementation, the processing unit PU may be operable to run one or more feed-back and/or feed-forward control loops which may be configured to determine the first deformation and the second deformation based on measurement of wafer grids before and after selective dielectric deposition and/or measurement of post-bonding grid error.

With reference to Figure 8, the processing unit PU may be operable to determine an amount of displacement for each of the first actuators ACT1 of the top substrate clamp EC1 based on the first set of measurement data and determine an amount of displacement for each of the second actuators ACT2 of the bottom substrate clamp EC2 based on the second set of measurement data. In an embodiment, the first set of measurement data may comprise a first measured grid representing a first surface profile of the first bonding surface BS1 and the second set of measurement data may comprise a second measured grid representing a second surface profile of the second bonding surface BS2. The processing unit PU may determine a first grid difference between the first measured grid to a first target grid and a second grid difference between the second measured grid and a second target grid. Based on the first grid difference and the second grid difference, the processing unit PU may further determine an amount of displacement for each of the plurality of first actuators ACT1 of the top substrate clamp EC1 and determine an amount of displacement for each of the plurality of first actuators ACT2 of the bottom substrate clamp EC2.

In an embodiment, the first target grid and the second target grid may be defined to optimize at least one parameter of the bonded substrate, which may comprise for example an overall overlay fingerprint. In an embodiment, the first target grid may be identical to the second target grid. As such, the first wafer grid and the second wafer grid are controllably deformed, respectively by the first electrostatic clamp EC1 and the second electrostatic clamp EC2, to a common grid. In an embodiment, where a post-bonding lithography process is required, the first target grid and the second target grid may be defined to pre-correct for a (e.g., overlay) fingerprint of a lithographic apparatus within which the post-bonding lithography process is to be performed on the bonded substrate.

At method step 740 and with reference to Figure 9, the first actuators ACT1 of the top substrate clamp EC1 are displaced, according to the amounts of displacement determined at method step 730, to impose the first deformation onto the first bonding surface BS1 of the first substrate W1; and the second actuators ACT2 of the bottom substrate clamp EC2 are displaced, according to the amounts of displacement determined at method step 730, to impose the second deformation onto the second bonding surface BS2 of the second substrate W2.

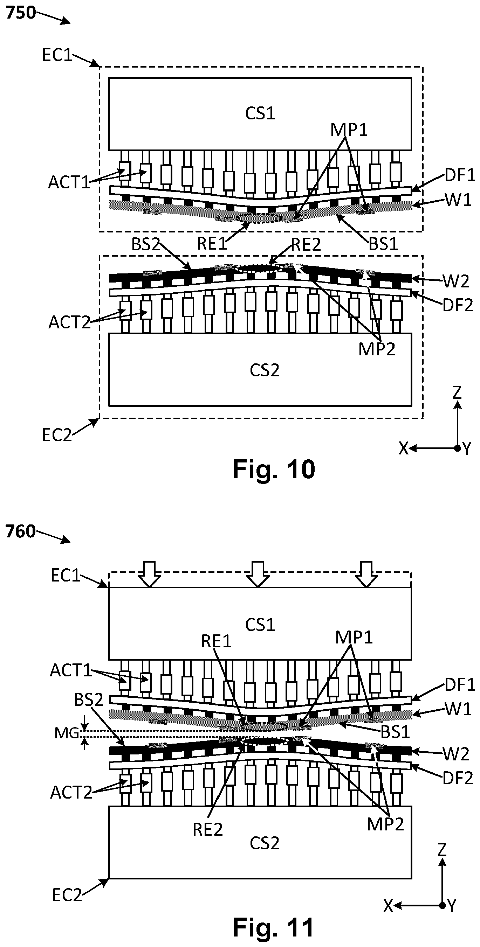

At method step 750 and with reference to Figure 10, the first substrate clamp EC1 is operable to bend a first region RE1 of the first bonding surface BS1 of the first substrate W1 towards the second substrate W2 and bend a second region RE2 of the second bonding surface BS2 of the second substrate W2 towards the first substrate W1. The first region RE1 of the first bonding surface BS1 of the first substrate W1 and the second region RE2 of the second bonding surface BS2 of the second substrate W2 may be bent only about the Y-axis (i.e. in the X-Z plane). In an alternative embodiment, the fist substrate W1 and the second substrate W2 may be bent about both the X-axis and the Y-axis. The bending of the first region RE1 of the first bonding surface BS1 may be achieved by displacing one or more first actuators ACT1 of the first substrate clamp EC1 located below and within the area of the first region RE1 of the first bonding surface BS1. The bending of the second region RE2 of the second bonding surface BS2 may be achieved by displacing one or more second actuators ACT2 located below and within the area of the second region RE2 of the second bonding surface BS2. The main purpose of bending the first substrate W1 and the second substrate W2 may be to reduce the aspect ratio for ALD.

In an embodiment, the first region may comprise a central region of the first bonding surface BS1 of the first substrate W1 and the second region may comprise a central region of the second bonding surface BS2 of the second substrate W2. In an alternative embodiment, the first region may comprise a non-central region of the first bonding surface BS1 of the first substrate W1 and the second region may comprise a non-central region of the second bonding surface BS2 of the second substrate W2.

The bending of the first substrate W1 and the bending of the second substrate W2 may be substantially symmetrical to each other; that is to say, the first substrate W1 and the second substrate may be bent towards each other and the amount of the bending of the first substrate W1 and the amount of the bending of the second substrate W2 may be substantially equal to each other. The (e.g., symmetrical) bending of the first substrate W1 and the second substrate W2 may provide an advantage of allowing the dielectric layer DL to be deposited between the first bonding surface BS 1 and the second bonding surface BS2 on a section-by-section basis. Each section (e.g., the first region RE1 or the second region RE2) may correspond to an area between two neighboring first or second metal pads MP 1, MP2. Depositing the dielectric layer DL over a smaller area rather than the full area of the first or second bonding surface BS1 or BS2 may enable a better control of the deposition process and thereby a more homogeneous dielectric layer.

At method step 760 and with reference to Figure 11, the first substrate clamp EC1 and/or the second substrate clamp EC2 are moved to bring the first region RE1 of the first bonding surface BS1 and the second region RE2 of the second bonding surface BS2 close to each other. In this particular example, the first region RE1 is a central region of the first bonding surface BS 1 and the second region RE2 is a central region of the second bonding surface BS2. The minimum gap MG between the first bonding surface BS1 and the second bonding surface BS2 corresponds to the gap between the first region RE1 of the first bonding surface BS1 and the second region RE2 of the second bonding surface BS2. The gap between the two bonding surfaces BS1, BS2 may continuously increase from the central regions to the peripheral regions of the two substrates W1, W2. The minimum gap MG may be flexibly set depending on the deposition technique adopted to deposit the dielectric layer. For example, in the case of the redox-coupled inherently selective ALD, the minimum gap between the first region RE1 of the first bonding surface BS1 and the second region RE2 of the second bonding surface BS2 may be between 5 nm and 200 nm. The gap between the two bonding surfaces BS1, BS2 may be negatively proportional to the throughput of the substrate bonding apparatus, i.e. the smaller the gap is, the higher the throughput will be.

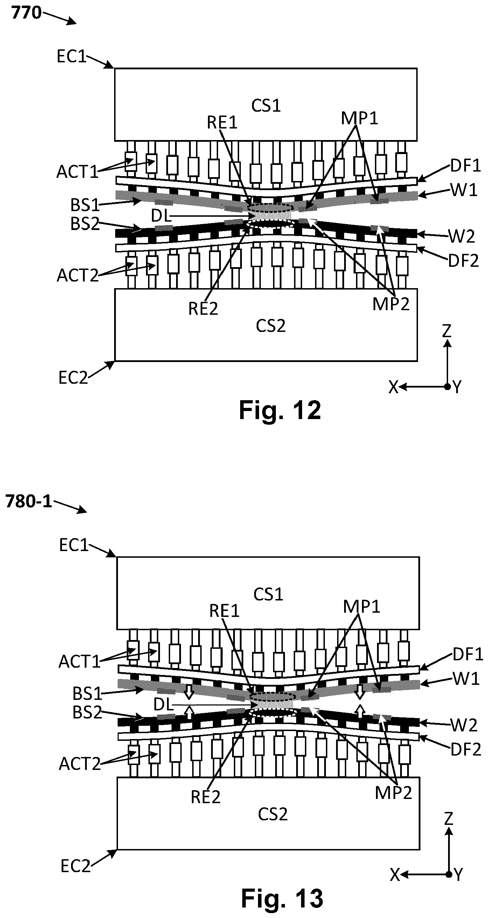

At method step 770 and with reference to Figure 12, a dielectric layer DL is deposited onto the first region RE1 of the first bonding surface BS1 and the second region RE2 of the second bonding surface BS2 to fill the gap therebetween. The dielectric layer DL may be composed of an oxide dielectric material such as for example TazOs which may be deposited using the redox-coupled inherently selective ALD. The deposition of the dielectric layer DL and the connection of one or more pairs of metal pads MP1, MP2 may be performed in an alternate manner. The dielectric layer DL may be deposited either before or after at least one of the first metal pads is brought into contact with a respective one of the second metal pads.

In the case where at least one first metal pad MP1 is present within the first region RE1 of the first bonding surface BS1 and at least one second metal pad MP2 is present within the second region RE2 of the second bonding surface BS2, such first metal pad MP1 and second metal pad MP2 may be brought into contact and subsequently connected with each other as a result of the elevated temperature required for depositing the dielectric layer DL. Before or during the deposition of the dielectric layer DL, the ambient temperature of the first metal pads MP1 and the second metal pads MP2 may increase to for example 200 °C to 300 °C. Such an elevated ambient temperature may lead to expansion and diffusion of the first metal pads MP1 and the second metal pads MP2 which may result in at least one of the first metal pads MP1 being brought into contact and subsequently connected with at least one of the second metal pads MP2s. After the at least one of the first metal pads MP1 is connected with the at least one of the second metal pads MP2, the dielectric layer DL may be deposited onto the first region RE1 of the first bonding surface BS1 and the second region RE2 of the second bonding surface BS2 to fill the gap therebetween. This process of first connecting the metal pads MP1, MP2 within a region and then depositing the dielectric layer DL to fill the gap in the region may be repeatedly performed until each of the first metal pads MP1 is connected to a respective one of the second metal pads MP2 and the gap between the first bonding surface BS1 and the second bonding surface BS2 is completely filled with the dielectric layer DL.

In the case where no first metal pad MP1 is present within the first region RE1 of the first bonding surface BS1 and no second metal pad MP2 is present within the second region RE2 of the second bonding surface BS2 (e.g., as shown in Figure 12), the dielectric layer DL may be deposited to fill the gap between the first region RE1 of the first bonding surface BS 1 and the second region RE2 of the second bonding surface BS2 first. Then, the first metal pad(s) MP1 immediately adjacent to the first region RE1 may be brought into contact and subsequently connected with the second metal pad(s) MP2 immediately adjacent to the second region RE2 as a result of the elevated temperature required for depositing the dielectric layer DL. This process of first depositing the dielectric layer DL to fill a regional gap and then connecting the metal pads MP1, MP2 immediately adjacent to the deposited region may be repeatedly performed until each of the first metal pads MP1 is connected to a respective one of the second metal pads MP2 and the gap between the first bonding surface BS1 and the second bonding surface BS2 is completely filled with the dielectric layer DL.

At method step 780 and with reference to Figure 13, while the above-described deposition-connection process (or connection-deposition process) is being performed, the first substrate clamp EC1 and the second substrate clamp EC2 are operable to gradually release the bending of the first region RE1 of the first bonding surface BS1 of the first substrate W1 and the bending of the second region RE2 of the second bonding surface BS2 of the second substrate W2, respectively. As indicated by arrows in Figure 13, releasing the bending of the first region RE1 may be achieved by displacing either parallelly or sequentially other first actuators ACT1 of the first substrate clamp EC1 to bring other regions (regions outside the first region) of the first bonding surface BS1 closer to the second bonding surface BS2; and releasing the bending of the second region RE2 may be achieved by displacing either parallelly or sequentially other second actuators ACT2 of the second substrate clamp EC2 to bring other regions of the second bonding surface BS2 closer to the first bonding surface BS 1.

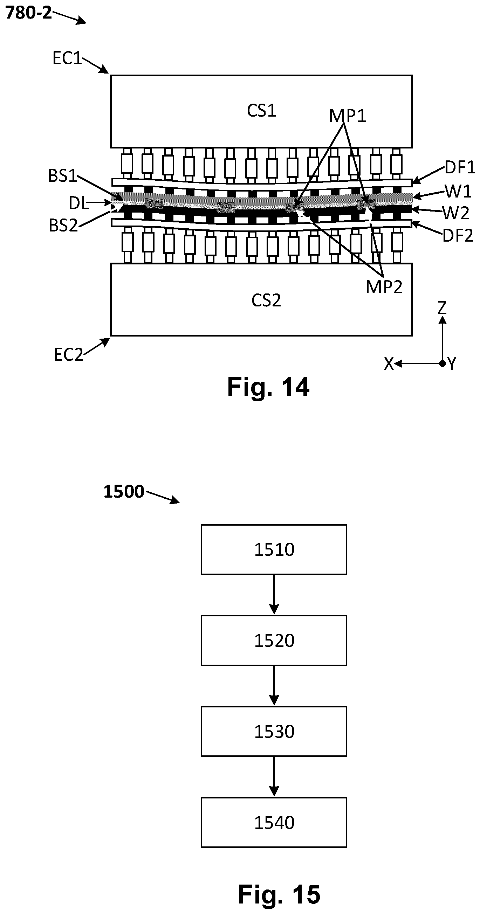

With reference to Figure 14, once the bending of the first region RE1 of the first bonding surface BS1 and the bending of the second region RE2 of the second bonding surface BS2 are both released, the first substrate clamp EC1 may still impose the first deformation (determined based on the first set of measurement data) onto the first bonding surface BS1 and the second substrate clamp EC2 may still impose the second deformation (determined based on the second set of measurement) onto the second bonding surface BS2. As such, the first bonding surface BS1 of the first substrate W1 may have a first wafer grid and the second bonding surface BS2 may have a second wafer grid which may be substantially matched to the first wafer grid (e.g., the first wafer grid is identical to the second wafer grid). This may ensure that when the gap between the first bonding surface BS 1 and the second bonding surface BS2 is completely filled with the dielectric layer DL and each of the first metal pads MP1 is connected to a respective one of the second metal pads MP2 either during the substate bonding process (i.e. while the first bonding surface BS1 is being bonded to the second bonding surface BS2) and/or during a post-bonding high temperature treatment (e.g., 200 °C to 300 °C) of the bonded substrate through heat-induced metal expansion and diffusion, at least one parameter of the bonded substrate, which may comprise for example an overall overlay fingerprint, may be optimized.

Note that the above-described method 700 is only a specific embodiment. Some of the method steps such as method steps 760 (bending the two bonding surfaces BS1, BS2) and 780 (releasing the bending of the two bonding surfaces BS1, BS2) may not be required in other embodiments. In such cases, the first substrate clamp EC1 may impose only the first deformation (thus no additional bending is required) onto the first bonding surface BS1 and the second substrate clamp EC2 may impose only the second deformation (thus no additional bending is required) onto the second bonding surface BS2. The dielectric layer DL may be continuously deposited onto the first bonding surface BS1 and the second bonding surface BS2 till the gap between the two bonding surfaces BS1 and BS2 is completely filled. As described above, during the deposition process, the elevated ambient temperature (e.g., 200 °C to 300 °C) may lead to expansion and diffusion of the first metal pads MP1 and the second metal pads MP2 which may result in the first metal pads MP1 being brought into contact and subsequently connected with the second metal pads MP2 in a parallel manner.

Another aspect of the present disclosure provides a method of bonding a first substrate to a second substrate, the first substrate comprising a first bonding surface and a plurality of first electrically conductive pads levelled with or recessed from the first bonding surface and the second substrate comprising a second bonding surface and a plurality of second electrically conductive pads levelled with or recessed from the second bonding surface.

With reference to Figure 15, the proposed method 1500 may comprise the following four main steps, i.e. steps 1510-1540.

Method step 1510 may comprise selectively depositing a dielectric layer onto the first bonding surface and/or the second bonding surface to (finely) adjust a first recess of the plurality of first electrically conductive pads with respect to the first bonding surface and/or a second recess of the plurality of second electrically conductive pads with respect to the second bonding surface, wherein an external surface of the dielectric layer deposited onto the first substrate is configured to provide the first bonding surface and an external surface of the dielectric layer deposited onto the second substrate is configured to provide the second bonding surface

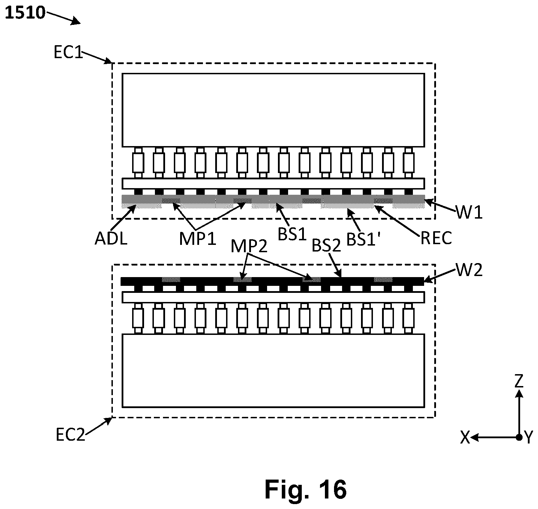

Figure 16 schematically depicts an example implementation of the method step 1510 of the proposed method 1500. As shown in Figure 16, a first substrate W1 is securely held by a first substrate clamp EC1 and a second substrate W2 is securely held by a second substrate clamp EC2. The first substrate clamp EC1 and the second substrate clamp EC2 may be of the same configuration as those described above in relation to the embodiments shown in Figures 8-14. The first substrate W1 comprises a first bonding surface BS1 and a plurality of first metal pads MP1 levelled with the first bonding surface. The second substrate W2 comprises a second bonding surface BS2 to be bonded to the first bonding surface BS2 and a plurality of second metal pads MP2 levelled with the second bonding surface BS2.

An additional dielectric layer ADL is deposited onto the first bonding surface BS1 of the first substrate W1. The external surface of the additional dielectric layer ADL that faces the second substrate W2 becomes the new first bonding surface BS 1'. By controlling the thickness of the additional dielectric layer ADL, it is possible to finely adjust the recess REC of the first electrically conductive pads MP1 with respect to the new first bonding surface BS1'. The deposition of the additional dielectric layer ADL may be achieved using e.g., the redox-coupled inherently selective ALD technique. By comparison, no additional dielectric layer is deposited onto the second substrate W2 and thus the second electrically conductive pads MP2 of the second substrate W2 remain levelled with the second bonding surface BS2.

Note that in a different example (not shown), an additional dielectric layer may be deposited onto the first substrate to adjust the recess of the first electrically conductive pads with respect to the new first bonding surface (which is the external surface of the first additional dielectric layer facing the second substrate) and a second additional dielectric layer may be deposited to the second substrate to adjust the recess of the second electrically conductive pads with respect to the new second bonding surface (which is the external surface of the second additional dielectric layer facing the first substrate).

Method step 1520 may comprise reducing a distance between the first bonding surface and the second bonding surface.

Method step 1530 may comprise bringing at least a portion of first bonding surface into contact with a corresponding portion of the second bonding surface. The step 1530 may be performed while one or both of the substates are controllably deformed (e.g., the example implementation as shown in Figure 10).

Method step 1540 may comprise bringing each of the first electrically conductive pads into electrical contact with a respective one of the second electrically conductive pads so as to obtain a bonded substrate; the electrical contact between the plurality of first electrically conductive pads and the plurality of second electrically conductive pads may be achieved either during step 1530 (i.e. during the substrate bonding process) and/or during a post-bonding high temperature treatment of the bonded substrate through heat-induced metal expansion and diffusion.

Similar to the embodiment shown in Figure 7, the proposed method 1500 may further comprise one or more additional steps such as the above-described method steps 710 to 750.

The proposed method 1500 may allow a larger degree of control of the recess of the first electrically conductive pads with respect to the first bonding surface and/or the recess of the second electrically conductive pads with respect to the second bonding surface, especially in the case when different electrically conductive pads have vastly different critical dimensions (e.g., transistors signal lines and power delivery lines), and when traditionally used methods such as CMP or wet etch are no longer adequate to achieve a uniform recess for all of the electrically conductive pads. Alternatively or in addition, selective deposition of the dielectric layer may allow to control strain and stress in one or both of the substrates to be bonded and thus may expand the range of correctable grid mismatches between the substrates to be bonded, compared to the conventional methods.

Further embodiments of the invention are disclosed in the list of numbered clauses below:
1. A method of bonding a first substrate to a second substrate, the first substrate comprising a first bonding surface and a plurality of first electrically conductive pads protruding from, or levelled with, or recessed from the first bonding surface and the second substrate comprising a second bonding surface and a plurality of second electrically conductive pads protruding from, or levelled with, or recessed from the second bonding surface, the method comprising: reducing a distance between the first bonding surface and the second bonding surface; selectively depositing a dielectric layer onto the first bonding surface and/or the second bonding surface to fill a gap therebetween; and bringing each of the first electrically conductive pads into electrical contact with a respective one of the second electrically conductive pads so as to obtain a bonded substrate.
2. A method of bonding a first substrate to a second substrate, the first substrate comprising a first bonding surface and a plurality of first electrically conductive pads levelled with or recessed from the first bonding surface and the second substrate comprising a second bonding surface and a plurality of second electrically conductive pads levelled with or recessed from the second bonding surface, the method comprising: selectively depositing a dielectric layer onto the first bonding surface and/or the second bonding surface to adjust a first recess of the plurality of first electrically conductive pads with respect to the first bonding surface and/or to adjust a second recess of the plurality of second electrically conductive pads with respect to the second bonding surface, wherein an external surface of the dielectric layer deposited onto the first substrate is configured to provide the first bonding surface and an external surface of the dielectric layer deposited onto the second substrate is configured to provide the second bonding surface; reducing a distance between the first bonding surface and the second bonding surface; bringing at least a portion of first bonding surface into contact with a corresponding portion of the second bonding surface; and bringing each of the first electrically conductive pads into electrical contact with a respective one of the second electrically conductive pads so as to obtain a bonded substrate.
3. A method according to clause 1 or 2, wherein the dielectric layer is deposited onto the first bonding surface and/or the second bonding surface using a redox-coupled inherently selective atomic layer deposition technique.
4. A method according to clause 3, wherein the dielectric layer is composed of TazOs.
5. A method according to any preceding clause, wherein the depositing step and the bringing step are performed in an alternate manner.
6. A method according to any preceding clause, further comprising, prior to the reducing step,
   bending a first region of the first bonding surface of the first substrate towards the second substrate; and bending a second region of the second bonding surface of the second substrate towards the first substrate.
7. A method according to clause 6, wherein the gap between the first bonding surface and the second bonding surface has a minimum of between 5 nm and 200 nm formed between the first region of the first bonding surface and the second region of the second bonding surface.
8. A method according to clause 7, further comprising, while the depositing step is being performed, gradually releasing the bending of the first region of the first bonding surface and the bending of the second region of the second bonding surface until the gap is completely filled.
9. A method according to any of clauses 6 to 8, wherein the first region comprises a central region of the first bonding surface of the first substrate and the second region comprises a central region of the second bonding surface of the second substrate.
10. A method according to any preceding clause, wherein the first substrate comprises a first top dielectric layer comprising the first bonding surface and the second substrate comprises a second top dielectric layer comprising the second bonding surface, the first top dielectric layer and/or the second top dielectric layer being composed of a different material to the dielectric layer deposited onto the first bonding surface and/or the second bonding surface.
11. A method according to any preceding clause, wherein the plurality of first electrically conductive pads are a plurality of first metal pads and/or the plurality of second electrically conductive pads are a plurality of second metal pads.
12. A method according to clause 11, wherein the plurality of first metal pads are formed within the first substrate using damascene processing, and/or the plurality of second metal pads are formed within the second substrate using damascene processing.
13. A method according to clause 11, wherein the plurality of first metal pads are formed within the first substrate by direct metal etching, and/or the plurality of second metal pads are formed within the second substrate using direct metal etching.
14. A method according to any of clauses 11 to 13, wherein the plurality of first metal pads are controllably recessed with respect to the first bonding surface at least in part during the selectively depositing step, and/or the plurality of the second metal pads are controllably recessed with respect to the second bonding surface at least in part during the selectively depositing step.
15. A method according to any preceding clause, further comprising: obtaining a first set of measurement data comprising measurements of the first substrate and a second set of measurement data comprising measurements of the second substrate.
16. A method according to clause 15, further comprising: measuring the first substrate to obtain the first set of measurement data and measuring the second substrate to obtain the second set of measurement data.
17. A method according to clause 15 or 16, further comprising :imposing a first deformation onto the first bonding surface of the first substrate based on the first set of measurement data and a second deformation onto the second bonding surface of the second substrate based on the second set of measurement data.
18. A method according to clause 17, wherein the first set of measurement data comprises a first measured grid representing a first surface profile of the first bonding surface and the second set of measurement data comprises a second measured grid representing a second surface profile of the second bonding surface.
19. A method according to clause 18, wherein the first deformation and the second deformation are determined by: determining a first grid difference between the first measured grid and a first target grid; determining a second grid difference between the second measured grid and a second target grid; determining the first deformation imposed by the first substrate clamp based on the first grid difference; and determining the second deformation imposed by the second substrate clamp based on the second grid difference.
20. A method according to clause 19, wherein the first target grid and the second target grid are defined to optimize at least one parameter of the bonded substrate.
21. A method according to clause 20, wherein the at least one parameter of the bonded substrate comprises an overall overlay fingerprint of the bonded substrate.
22. A method according to clause 20 or 21, wherein the first target grid is identical to the second target grid.
23. A method according to any of clauses 20 to 22, wherein the first target grid and the second target grid are defined to pre-correct for a fingerprint of a post-bonding lithography step to be performed on the bonded substrate.
24. A method according to any preceding clause, further comprising heating the bonded substrate to increase or establish electrical contact between the plurality of first electrically conductive pads and the plurality of second electrically conductive pads through heat-induced expansion and diffusion.
25. A substrate bonding apparatus for bonding a first substrate to a second substrate, comprising:
   a first substrate clamp for securely holding a first substrate comprising a first bonding surface and a plurality of first electrically conductive pads protruding from, or levelled with, or recessed from the first bonding surface; a second substrate clamp for securely holding a second substrate comprising a second bonding surface and a plurality of second electrically conductive pads protruding from, or levelled with, or recessed from the second bonding surface; and an atomic layer deposition reactor configured to selectively deposit a dielectric layer onto the first bonding surface and/or the second bonding surface to fill a gap therebetween or to selectively deposit a dielectric layer onto the first bonding surface and/or the second bonding surface to adjust a first recess of the plurality of first electrically conductive pads with respect to the first bonding surface and/or a second recess of the plurality of second electrically conductive pads with respect to the second bonding surface; and a heating apparatus configured to heat up a bonded substrate so as to increase or establish electrical contact between the plurality of first electrically conductive pads and the plurality of second electrically conductive pads through heat-induced expansion and diffusion.
26. A substrate bonding apparatus according to clause 25, wherein one or both of the first substrate clamp and the second substrate clamp is an electrostatic clamp or a vacuum clamp.
27. A substrate bonding apparatus according to clause 26, wherein the first substrate clamp comprises a plurality of first actuators embedded therewithin and operable to displace along at least a direction perpendicular to a transversal plane in which the first substrate is held and/or the second substrate clamp comprises a plurality of second actuators embedded therewithin and operable to displace along at least a direction perpendicular to a transversal plane in which the second substrate is held; and wherein the first substrate clamp and/or the second substrate clamp are configured such that displacement of one or more of the plurality of first actuators of the first electrostatic clamp causes a deformation of the first bonding surface of the first substrate and/or displacement of one or more of the plurality of second actuators of the second electrostatic clamp causes a deformation of the second bonding surface of the second substrate.
28. A substrate bonding apparatus according to clause 27, wherein the plurality of first actuators and/or the plurality of second actuators are piezo actuators.
29. A substrate bonding apparatus according to any of clauses 26 to 28, wherein the atomic layer deposition reactor is operable to provide an operating temperature of between 200 °C to 300 °C for the deposition of the dielectric layer.
30. A substrate bonding apparatus according to any of clauses 25 to 29, being operable to perform the method of any of clauses 1 to 24.
31. A bonded substrate obtained by performing the method of any of clauses 1 to 24.
32. A computer program comprising program instructions operable to perform the method of any of clauses 19 to 24, when run on a processing resource.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and substrate optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method of bonding a first substrate to a second substrate, the first substrate comprising a first bonding surface and a plurality of first electrically conductive pads protruding from, or levelled with, or recessed from the first bonding surface and the second substrate comprising a second bonding surface and a plurality of second electrically conductive pads protruding from, or levelled with, or recessed from the second bonding surface, the method comprising:
reducing a distance between the first bonding surface and the second bonding surface;
selectively depositing a dielectric layer onto the first bonding surface and/or the second bonding surface to fill a gap therebetween; and
bringing each of the first electrically conductive pads into electrical contact with a respective one of the second electrically conductive pads so as to obtain a bonded substrate.

2. A method as claimed in claim 1, wherein the dielectric layer is deposited onto the first bonding surface and/or the second bonding surface using a redox-coupled inherently selective atomic layer deposition technique.

3. A method as claimed in claim 1, wherein the depositing step and the bringing step are performed in an alternate manner.

4. A method as claimed in claim 1, further comprising, prior to the reducing step,
bending a first region of the first bonding surface of the first substrate towards the second substrate; and
bending a second region of the second bonding surface of the second substrate towards the first substrate.

5. A method as claimed in claim 4, wherein the gap between the first bonding surface and the second bonding surface has a minimum of between 5 nm and 200 nm formed between the first region of the first bonding surface and the second region of the second bonding surface.

6. A method as claimed in claim 5, further comprising, while the depositing step is being performed, gradually releasing the bending of the first region of the first bonding surface and the bending of the second region of the second bonding surface until the gap is completely filled.

7. A method as claimed in any of claims 4 to 6, wherein the first region comprises a central region of the first bonding surface of the first substrate and the second region comprises a central region of the second bonding surface of the second substrate.

8. A method as claimed in claim 1, wherein the first substrate comprises a first top dielectric layer comprising the first bonding surface and the second substrate comprises a second top dielectric layer comprising the second bonding surface, the first top dielectric layer and/or the second top dielectric layer being composed of a different material to the dielectric layer deposited onto the first bonding surface and/or the second bonding surface.

9. A method as claimed in claim 1, wherein the plurality of first electrically conductive pads are a plurality of first metal pads and/or the plurality of second electrically conductive pads are a plurality of second metal pads.

10. A method as claimed in claim 1, further comprising:
obtaining a first set of measurement data comprising measurements of the first substrate and a second set of measurement data comprising measurements of the second substrate.

11. A method as claimed in claim 10, further comprising:
imposing a first deformation onto the first bonding surface of the first substrate based on the first set of measurement data and a second deformation onto the second bonding surface of the second substrate based on the second set of measurement data.

12. A method as claimed in claim 1, further comprising heating the bonded substrate to increase or establish electrical contact between the plurality of first electrically conductive pads and the plurality of second electrically conductive pads through heat-induced expansion and diffusion.

13. A substrate bonding apparatus for bonding a first substrate to a second substrate, comprising:
a first substrate clamp for securely holding a first substrate comprising a first bonding surface and a plurality of first electrically conductive pads protruding from, or levelled with, or recessed from the first bonding surface;
a second substrate clamp for securely holding a second substrate comprising a second bonding surface and a plurality of second electrically conductive pads protruding from, or levelled with, or recessed from the second bonding surface; and
an atomic layer deposition reactor configured to selectively deposit a dielectric layer onto the first bonding surface and/or the second bonding surface to fill a gap therebetween or to selectively deposit a dielectric layer onto the first bonding surface and/or the second bonding surface to adjust a first recess of the plurality of first electrically conductive pads with respect to the first bonding surface and/or a second recess of the plurality of second electrically conductive pads with respect to the second bonding surface; and
a heating apparatus configured to heat up a bonded substrate so as to increase or establish electrical contact between the plurality of first electrically conductive pads and the plurality of second electrically conductive pads through heat-induced expansion and diffusion.

14. A substrate bonding apparatus as claimed in claim 13, wherein one or both of the first substrate clamp and the second substrate clamp is an electrostatic clamp or a vacuum clamp and wherein the first substrate clamp comprises a plurality of first actuators embedded therewithin and operable to displace along at least a direction perpendicular to a transversal plane in which the first substrate is held and/or the second substrate clamp comprises a plurality of second actuators embedded therewithin and operable to displace along at least a direction perpendicular to a transversal plane in which the second substrate is held; and
wherein the first substrate clamp and/or the second substrate clamp are configured such that displacement of one or more of the plurality of first actuators of the first electrostatic clamp causes a deformation of the first bonding surface of the first substrate and/or displacement of one or more of the plurality of second actuators of the second electrostatic clamp causes a deformation of the second bonding surface of the second substrate.

15. A bonded substrate obtained by performing the method of any of claims 1 to 4.
